Europäisches Patentamt

European Patent Office

Office européen des brevets

(11) Veröffentlichungsnummer: **0 244 729**
**A1**

## (12) EUROPÄISCHE PATENTANMELDUNG

(21) Anmeldenummer: 87106091.9

(22) Anmeldetag: 27.04.87

(51) Int. Cl.4: **H03M 7/30 , H04B 14/04**

(30) Priorität: 30.04.86 DE 3614690

(43) Veröffentlichungstag der Anmeldung:
**11.11.87 Patentblatt 87/46**

(84) Benannte Vertragsstaaten:
**AT CH DE FR GB IT LI NL SE**

(71) Anmelder: **Siemens Aktiengesellschaft Berlin und München**
**Wittelsbacherplatz 2**
**D-8000 München 2(DE)**

(72) Erfinder: **Günther, Pexa**
**Brüchenweg 2A**
**D-8031 Wörthsee(DE)**

(54) **Verfahren zur Übertragung von DPCM-Werten.**

(57) Verfahren zur Übertragung von DPCM-Werten, bei dem mehrere aufeinanderfolgende DPCM-Werte in Datenwörter gleicher, möglichst minimaler Länge umgesetzt werden und daß die Datenwörter mit einer ihre Länge kennzeichnender Präambel zu einem Datenblock konstanter Länge zusammgefaßt und ausgesendet werden.

# FIG 5

5.1  0 |a a|a a|a a|a a|

5.2  1 0 |b b b|b b b|b b b|

5.3  1 1 0 |c c c c|c c c c|

5.4  1 1 1 0 | PCM |

5.5  1 1 1 1 0 | RL |

5.6  0 1 1 0 0 0 0 1 0 1 |P|

5.7  1 1 1 1 1 1 0 |c c c c|

EP 0 244 729 A1

## Verfahren zur Übertragung von DPCM-Werten

Die Erfindung betrifft ein Verfahren zur Übertragung von DPCM-Werten durch Datenwörter unterschiedlicher Länge.

Bei der Übertragung von digitalisierten Abtastwerten wird zur Datenreduktion häufig ein Differenz-Pulscode-Modulationsverfahren (DPCM) angewendet. Das ursprüngliche Signal - hierbei handelt es sich beispielsweise um ein Ton-oder ein Bildsignal - wird zunächst in ein elektrisches Signal umgewandelt, abgetastet und anschließend digitalisiert. Anstelle der so gewonnenen digitalisierten Abtastwerte wird jeweils nur die Differenz des aktuellen Abtastwertes zu einem aus vorhergehenden Abtastwerten berechneten Schätzwert übertragen. Hierzu wird die als DPCM-Wert bezeichnete Differenz zunächst quantisiert und anschließend als codiertes DPCM-Wort übertragen. Zur weiteren Datenreduktion ist es bekannt, eine sogenannte Optimalcodierung - beispielsweise nach Shannon-Fano oder Huffman - vorzunehmen, bei der die Häufigkeit des Auftretens einzelner Codewörter berücksichtigt wird. Der hierdurch bedingte unregelmäßige Datenfluß erfordert einen beträchtlichen Schaltungsaufwand bei der empfangsseitigen Rekonstruktion der ursprünglichen Abtastwerte. Außerdem ist dies Verfahren störanfällig bei Übertragungsfehlern und bewirkt nur eine relativ geringe Datenreduktion.

Aufgabe der Erfindung ist es, ein einfach realisierbares Verfahren zur Codierung von DPCM-Werten anzugeben, das nur einfache Maßnahmen zur Synchronisation benötigt und außerdem eine wesentliche Datenreduktion bewirkt.

Die Aufgabe wird durch die im Patentanspruch 1 angegebenen Merkmale gelöst.

Vorteilhafte Ausbildungen der Erfindung sind in den Unteransprüchen angegeben.

Eine einfache Synchronisation ist bereits durch die konstante Blockbildung möglich. Durch die Zusammenfassung von Datenwörtern gleicher Länge zu jeweils einem Datenblock ist nur eine minimale zusätzliche Information zur Kennzeichnung der Wortgrenzen notwendig.

Durch ein Synchronwort, daß beispielsweise am Anfang jeder Fernsehzeile ausgesendet wird, ist auch bei starken Übertragungsstörungen eine Synchronisierung zwischen Sender und Empfänger möglich.

Durch die Aussendung von PCM-Wörtern werden außerdem kritische Bildteile mit höchster Qualität übertragen und durch eine Run-Length-Codierung wird bei gleichförmigen Bildsignalen die zu übertragene Datenrate noch weiter reduziert. Die Übertragung von Steuersignalen ermöglicht außerdem stets eine optimale Verwendung von unterschiedlichen Prädiktoren oder auch von unterschiedlichen Quantisierungsmöglichkeiten, wobei die Steuerkriterien hierzu nicht aus den empfangenen DPCM-Werten hergeleitet werden müssen.

Anhand von Beispielen wird das Verfahren näher erläutert.

Es zeigen

Fig. 1 ein Prinzipschaltbild eines DPCM-Senders,

Fig. 2 ein Prinzipschaltbild eines umschaltbaren DPCM-Senders,

Fig. 3 ein Prinzipschaltbild zur erfindungsgemäßen Codierung,

Fig. 4 ein Prinzipschaltbild eines DPCM-Empfängers,

Fig. 5 ein Beispiel zur Codierung von Datenblöcken,

Fig. 6 ein weiteres Beispiel zur Codierung von Datenblöcken und

Fig. 7 ein Prinzipschaltbild einer Anordnung zur Codierung von Datenblöcken.

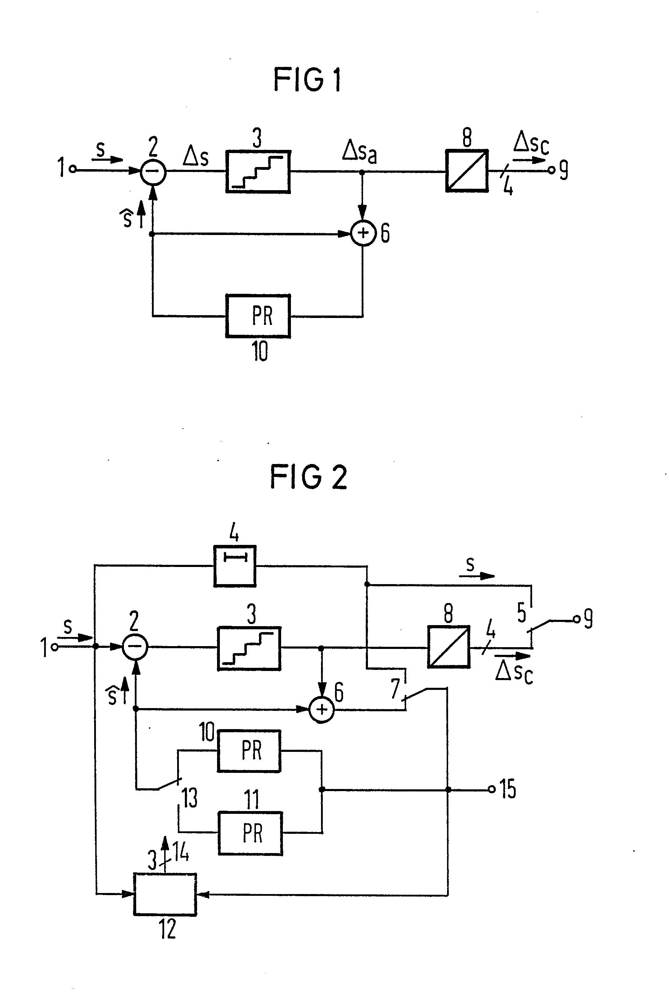

In Fig. 1 ist ein Prinzipschaltbild eines DPCM-Senders dargestellt. Der Eingang 1 ist mit einem Subtrahierer 2 verbunden, dessen Ausgang an den Eingang eines Quantisierers 3 angeschaltet ist. Der Ausgang des Quantisierers ist über einen Addierer 6 und einen Prädiktor (PR) 10 auf den Subtraktionseingang des Subtrahierers 2 rückgekoppelt. Außerdem ist der Ausgang des Prädiktors 10 mit einem zweiten Eingang des Addierers 6 verbunden. An den Ausgang des Quantisierers ist außerdem ein Codierer 8 angeschaltet, dessen Ausgang mit 9 bezeichnet ist.

Das erfindungsgemäße Verfahren soll anhand der Übertragung von Fernsehsignalen beschrieben werden. Aus Gründen der Vereinfachung wird hier nicht weiter zwischen Luminanz-und Chrominanzsignalen unterschieden, die im allgemeinen in verschiedenen DPCM-Sendern codiert und im Zeitmultiplexverfahren ausgesendet werden.

Dem Eingang 1 werden digitalisierte Abtastwerte s, sie entsprechen Bildpunkten, zugeführt. Im Subtrahierer 2 wird jeweils die Differenz zwischen einem Abtastwert s und einem Schätzwert $\hat{s}$ gebildet und der so ermittelte DPCM-Wert $\Delta s$ wird dem Quantisierer 3 zugeführt, der an seinem Ausgang quantisierte DPCM-Werte $\Delta s_q$ abgibt. Diese werden im Codierer 8 in codierte DPCM-Werte $\Delta s_c$ umgesetzt. die beispielsweise alle eine Länge von vier Bits aufweisen. Der Ausgang 9 führt zu den Modulations einrichtungen des DPCM-Senders.

2

Es ist außerdem bekannt, den Quantisierer und den Codierer in Abhängigkeit von den Abtastwerten zu steuern und eine Optimalcodierung der quantisierten DPCM-Werte $\Delta s_q$ vorzunehmen.

In Fig. 2 ist ein erweitertes Prinzipschaltbild eines umschaltbaren DPCM-Senders dargestellt, das zur Erläuterung des erfindungsgemäßen Verfahrens dienen soll.

Der Eingang 1 ist wiederum mit der Reihenschaltung des Subtrahierers 2 und des Quantisierers 3 verbunden. Der Ausgang des Addierers 6 ist jedoch über einen Umschalter 7, dessen zweiter Eingang über ein Laufzeitglied 4 mit dem Eingang 1 verbunden ist, mit den Eingängen zweier Prädiktoren 10 und 11 verbunden sowie mit dem Eingang einer Sender-Steuerung 12, die hier einen weiteren Eingang aufweist, der mit dem Eingang 1 des DPCM-Senders verbunden ist. Jeweils der Ausgang eines Prädiktors ist über einen weiteren Umschalter 13 auf den Subtraktionseingang des Subtrahierers 2 rückgekoppelt. Außerdem ist ein dritter Umschalter 5 vorgesehen, der wahlweise den Ausgang des Codierers 8 oder den Ausgang des Laufzeitgliedes 4 an den Ausgang 9 des DPCM-Senders durchschaltet.

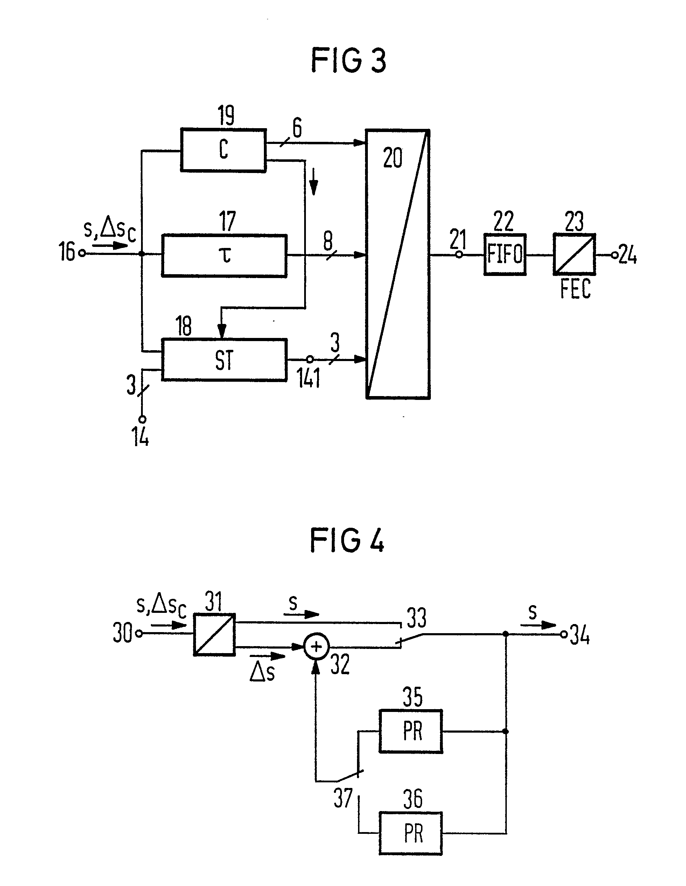

An den Ausgang 9 ist der Eingang 16 einer Codiereinrichtung angeschaltet, die in Fig. 3 dargestellt ist. Der Eingang 16 ist mit den Eingängen einer Codiersteuerung 18, eines Schieberegisters 17 und eines Zählers 19 verbunden. Die Ausgänge der Codiersteuerung, des Schieberegisters und des Zählers sind mit Paralleleingängen einer Anordnung zur Codierung von Datenblöcken 20 verbunden, die kurz als Codierschaltung bezeichnet wird. Dem Ausgang 21 der Codierschaltung ist ein Pufferspeicher 22 (FIFO: FIRST IN - FIRST OUT) und gegebenenfalls ein FEC-Coder (Forward Error Correction) nachgeschaltet, der an seinem Ausgang 24 gesicherte Daten abgibt. Bei einer blockweisen Datensicherung wird die Reihenfolge von Pufferspeicher und FEC-Coder zweckmäßigerweise vertauscht.

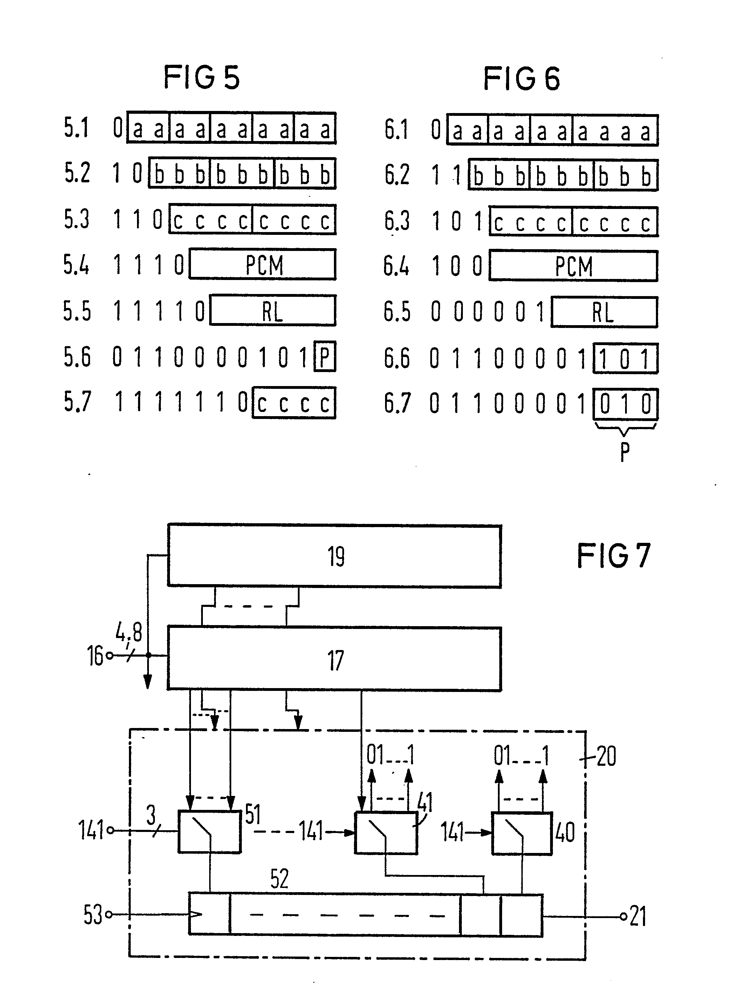

Bevor die Wirkungsweise der Codiereinrichtung nach Fig. 3 näher erläutert wird, soll anhand der Fig. 5 und 6 zunächst die angestrebte Zusammenfassung der vom DPCM-Coder abgegebenen DPCM-Werte zu Datenblöcken näher erläutert werden. Hierbei wird von folgender Überlegung ausgegangen: Umfassen die vom Coder 8 abgegebenen DPCM-Werte von jeweils 16 oder 15 möglichen Werten (entsprechend den möglichen Binärkombinationen bei einer Wortbreite von 4 Bits) jeweils nur wenige Werte, beispielsweise nur die betragsmäßig kleinsten drei Werte 0, +1 und -1, die drei Amplitudenstufen entsprechen, so können diese drei Werte mit nur zwei Bits "aa" codiert werden. Fünf dieser DPCM-Werte werden zusammen mit einer nur ein Bit umfassenden Präambel zu einem Datenblock nach Fig. 5.1 zusammengefaßt. Entspricht ein DPCM-Wert eines Datenblocks einem größeren Amplitudenwert, so erfolgt die Codierung mit drei Bits "bbb", wobei jeweils drei DPCM-Werte mit einer zwei Bits umfassenden Präambel zu einem Datenblock von ebenfalls 11 Bitslänge zusammengefaßt werden. Ist auch dies wegen eines zu großen DPCM-Wertes nicht möglich, so muß die ursprüngliche Wortbreite von vier Bits "cccc" beibehalten werden und eine Codierung nach Fig. 5.3 erfolgen, bei die Präambel nunmehr drei Bits umfaßt. Es wird somit stets versucht, möglichst viele DPCM-Werte in einem Datenblock zusammenzufassen, wobei der betragsmäßig größte DPCM-Wert die Anzahl der für die Codierung aller Datenwörter des Datenblockes aufzuwendenden Bits festlegt. Die Präambeln sind so gewählt, daß die entsprechenden Datenblöcke eindeutig gekennzeichnet sind.

Mit der bisher beschriebenen Codierung läßt sich bereits eine erhebliche Datenreduktion bei einem DPCM-Sender nach Fig. 1 erreichen. Das erfindungsgemäße Verfahren gestattet jedoch auch kompliziertere Codiervorgänge, mit dem erweiterten DPCM-Sender nach Fig. 2 vorteilhaft durchzuführen, wobei natürlich nicht alle der nachstehend beschriebenen Codiermöglichkeiten ausgenutzt werden müssen.

Anstelle eines DPCM-Wertes kann die Übertragung eines PCM-Wertes nach Fig. 5.4 während eines kritischen Bildteiles (beispielsweise Bildkanten, Gitter) erfolgen. Ebenso kann entsprechend Zeile 5.5 bei gleichbleibenden Bildteilen die Übertragung der Anzahl von Bildpunkten vorgenommen werden, bei denen sich die Abtastwerte nicht ändern und die DPCM-Werte daher Null sind - üblicherweise als Run-Length-Codierung "RL" bezeichnet. Ferner kann ein Synchronwort nach Fig. 5.6 am Anfang jeder Fernsehzeile übertragen werden, wobei der Datenblock außer dem Synchronwort noch ein oder mehrere Bits als Prädiktor-Kennzeichnung P aufweist. Es kann auch nach Fig. 5.7 auch eine spezielle Präambel vorgesehen sein, die anzeigt, daß nur ein einziger DPCM-Wert übertragen wird, wobei dies DPCM-Wort auch mehr als die üblichen 4 Bits zur Übertragung extremer Differenzen aufweisen kann. Die Anzahl der Übertragungsmöglichkeiten ist durch die angegebenen Beispiele noch nicht erschöpft. So können, durch eine spezielle Präambel gekennzeichnet, auch Steuersignale übertragen werden, die der Auswahl eines bestimmten Prädiktors entsprechen oder beispielsweise den Quantisierer umschalten. Eine besonders interessante Variante soll noch näher erläutert werden. Wenn nicht sämtliche möglichen Binärkombinationen übertragen werden müssen, beispielsweise nehmen die DPCM-Werte nach Fig. 5.1 nur die Werte 01, 10 und 11 an, so kann die verbleibende Kombination, hier 00, als Steuerzeichen übertragen werden. Dasselbe gilt für die Fig. 5.2 und 5.3, bei denen das Steuerzeichen "000" bzw. "0000" entspricht.

Unter der Voraussetzung, daß eine Bitkombination für Steuersignale reserviert ist, ist in Fig. 6 eine besonders günstige Codierungsform angegeben, bei der zwei jeweils nur drei Bits lange Präambeln in Fig. 6.3 und Fig. 6.4 vorgesehen sind, wodurch ein PCM-Wort von 8 Bits Länge übertragbar ist. Die in Fig. 6.5 vorgesehene Präambel kann nicht durch eine spezielle Bitkombination nach Fig. 6.1 vorgetäuscht werden, da die Präambel zwei aufeinanderfolgende Steuersignale enthält, zwei aufeinanderfolgende Steuersignale jedoch sendeseitig nie ausgesendet werden. Das Steuersignal wird vorteilhaft zur Umschaltung zwischen zwei Prädiktoren verwendet, wobei ein Prädiktor eine Interframe-Codierung (zweidimensional) und der andere eine Interframe-Codierung (unter Verwendung des vorangegangenen Fernsehbildes) oder Interfield-Codierung durchführt.

In jeder Fernsehzeile muß die gleiche Anzahl von Bildpunkten übertragen werden. Am Ende einer Fernsehzeile kann es also erforderlich sein, daß nur noch ein einziger DPCM-Wert übertragen werden soll. Dann ist eine Codierung nach Fig. 5.7 in Betracht zu ziehen, ebenso kann jedoch auch statt eines DPCM-Wertes ein PCM-Wert übertragen werden oder eine Kombination eines DPCM-Wertes nach Fig. 5.3 oder 6.3 und eines Steuersignales, das am Ende einer Fernsehzeile wirkungslos bleibt, wenn beim nächsten Zeilenanfang der Prädiktor neu ausgewählt wird. Dasselbe Problem ergibt sich entsprechend bei der Übertragung eines PCM-Wertes, wenn vor diesem nur ein einziger DPCM-Wert zu übertragen ist. Dies Problem kann durch eine Codierung entsprechend Fig. 5.7, durch die Übertragung zweier PCM-Werte oder durch die Übertragung der Zahl 0 bei einer Run-Length-Codierung entsprechend Fig. 5.5. oder 6.5 erfolgen.

Die Zusammenfassung von DPCM-Wert zu Datenblöcken muß keineswegs in der vorgeschriebenen Form erfolgen. Die Kennzeichnung der Datenblöcke kann auch beispielsweise dadurch erfolgen, daß von den insgesamt möglichen Kombinationen $2^{10}$ Kombinationen für die Übertragung von 2 Daten entsprechend Fig. 5.1 bzw. Fig. 6.1 ausgewählt werden; für die Übertragung von Datenblöcken entsprechend Fig. 5.2 bzw. 6.2 sind $2^5$ Kombinationen vorgesehen usw. Bei dieser Vorgehensweise ist jedoch ein höherer Schaltungsaufwand erforderlich.

Die Blocklänge sollte weder zu groß noch zu klein gewählt werden und zwischen 10 und 20 Bits liegen. Außer der beispielsweise angegebenen Blocklänge von 11 Bits erscheint auch eine Blocklänge mit 14 Bits besonders geeignet, wobei für die Präambel mindestens zwei Bits vorgesehen sind.

Der in Fig. 2 dargestellte umschaltbare DPCM-Sender führt die vorstehend beschriebenen Codierungsvarianten durch. Über den Umschalter 13 wird der geeignete Prädiktor 10, 11 ausgewählt und der Umschalter 5 ermöglicht die Aussendung eines PCM-Wertes, der über den Umschalter 7 - um einen Gleichlauf mit dem DPCM-Empfänger zu gewährleisten - der PCM-Wert den Prädiktoren zugeführt wird.

In Fig. 3 werden dem Eingang 16 der Codiereinrichtung vom Ausgang 9 des erweiterten DPCM-Senders bereits mit gleicher Breite von 4 Bits codierte DPCM-Werte und 8 Bits umfassende PCM-Werte zugeführt. Diese werden in das Schieberegister 17 eingeschrieben, wobei gleichzeitig der Codiersteuerung 18 mitgeteilt wird, um welche Art von Werten es sich handelt. Insgesamt fünf DPCM-Werte oder PCM-Werte werden im Schieberegister gespeichert. Die Codiersteuerung überprüft gleichzeitig wie viele Bits jeweils zur Codierung von DPCM-Werten notwendig sind. Sind beispielsweise bei fünf aufeinanderfolgenden DPCM-Werten nur jeweils zwei Bits erforderlich, so kann die Codierung nach Fig. 5.1 erfolgen. In der Codierschaltung 20 wird den codierten Datenwörtern eine Präambel "0" vorangestellt und der gesamte Datenblock seriell oder parallel ausgesendet. Sind jedoch für den vierten DPCM-Wert drei oder vier Bits zur Codierung erforderlich, werden die ersten drei DPCM-Werte in Datenwörter mit jeweils drei Bits nach Fig. 5.2 oder 6.2 umgesetzt und der vierte DPCM-Wert wird mit den folgenden DPCM-Werten im folgenden Datenblock übertragen. Außerdem wird durch den Zähler 19 ständig überprüft, wie häufig aufeinanderfolgend keine Änderung der Abtastwerte erfolgt bzw. DPCM-Werte "0" auftreten. Ist dies bei mehr als fünf DPCM-Werten der Fall, so wird die Run-Length-Codierung nach Fig. 5.5 durchgeführt. Ebenso können Steuersignale, die über den Eingang 14 der Codiersteuerung 18 zugeführt werden, über die Codierschaltung 20 in entsprechende Datenblöcke umcodiert werden. Die Codiersteuerung veranlaßt außerdem die Aussendung des Rahmenkennungswortes.

Der Pufferspeicher 22 sorgt für einen kontinuierlichen Datenfluß an seinem Ausgang, wobei er in bekannter Weise in Abhängigkeit von seinem Füllgrad beispielsweise den Quantisierer oder auch die Codiereinrichtung steuert. Durch den FEC-Coder werden die übertragenen Daten gegen Störungen auf dem Übertragungswege geschützt. Der Schutz kann sich hierbei auf die Präambel und die höherwertigeren Bits beschränken.

In Fig. 7 ist die Codierschaltung 20 detaillierter dargestellt. Sie enthält im wesentlichen ein Schieberegister 52, daß 11 in Serie geschaltete Kippstufen aufweist. An Paralleleingänge dieses Schieberegisters sind Multiplexer 40 bis 51 eingeschaltet. Die Eingänge des ersten Multiplexers 40 sind an feste Potentiale geschaltet, die den in Fig. 5, erste Spalte angegebenen logischen Zuständen entsprechen. Der zweite Multiplexer 41 hat einmal die Aufgabe, das erste Informationsbit nach der Präambel entsprechend Fig. 5.1 in das Schieberegister einzuspeichern und ist deshalb mit einem entsprechenden Ausgang des Schieberegisters 17 verdrahtet. Alle weiteren Eingänge dieses Multiplexers sind wiederum entsprechend Fig. 5, Spalte 2 an feste Potentiale gelegt. Entsprechend sind die Eingänge der weiteren Multiplexer mit den Ausgängen des Schieberegisters 17 und des Zählers 19 verdrahtet oder ebenfalls an feste Potentiale geschaltet. Die Steuerung der Multiplexer erfolgt vom Ausgang 141 der Codiersteuerung 18. Mit drei Steuerleitungen können bis zu 8 verschiedene Arten von Codeblöcken realisiert werden. Durch einen am Eingang 53 anliegenden Takt kann das Schieberegister 52 gleichzeitig als Parallel-Seriell-Umsetzer verwendet werden, wobei die Daten am Ausgang 21 in serieller Form abgegeben werden. Selbstverständlich sind auch andere Realisierungsmöglichkeiten der Codierschaltung denkbar.

Der DPCM-Empfänger hat die Aufgabe, die empfangenen Codeblöcke wieder in Abtastwerte s rückzuwandeln. Ein solcher DPCM-Empfänger ist in Fig. 4 dargestellt. Über einen Eingang 30 werden einem Decodierer 30 die Datenblöcke zugeführt. Dieser enthält einen elastischen Speicher und eine Decodieranordnung, so daß an den Ausgängen des Decodierers bereits DPCM-Werte Δ s oder Abtastwerte s abgegeben werden. Beide Ausgänge sind über einen Umschalter 33 mit einem Ausgang 34 verbunden. Über zwei Prädiktoren 35 und 36 sowie über einen Umschalter 37 ist der Ausgang auf einen Addierer 32 rückgekoppelt, dem außerdem die DPCM-Signale Δ $s_c$ zugeführt werden. In der DPCM-Schleife werden aus den DPCM-Werten Δ s wiederum die Abtastwerte s rekonstruiert. Der Ausgang 34 entspricht hierbei dem lokalen Ausgang 15 des DPCM-Senders. Die Betätigung der Umschalter 33 und 37 erfolgt ebenfalls von der Decodiereinrichtung. Auf Einzelheiten bei der Darstellung des DPCM-Empfängers wurde verzichtet, da dieser eine dem DPCM-Sender entsprechende Funktion aufweist. Einrichtungen zur Synchronisierung auf das Rahmenkennungswort und auf eine bestimmte Blocklänge sind ebenso bekannt, so daß hierauf nicht eingegangen werden braucht.

Der Einsatz der Erfindung ist keineswegs auf die beschriebenen Varianten der DPCM-Codierung beschränkt. Da sie sowohl eine erhebliche Datenreduktion ermöglicht als auch die Übertragung von mehreren Steuerkriterien und ebenfalls die Übertragung von PCM-codierten Werten gestattet.

## Ansprüche

1. Verfahren zur Übertragung von DPCM-Werten durch Umsetzen in Datenwörter unterschiedlicher Länge,
**dadurch gekennzeichnet,**
daß mehrere aufeinanderfolgende DPCM-Werte in Datenwörter (aa, bbb, cccc) gleicher, möglichst minimaler Länge umgesetzt werden und daß die Datenwörter (aa, bbb, cccc) mit einer ihre Länge kennzeichnender Präambel (0, L0, LL0) jeweils zu einem Datenblock konstanter Länge zusammengefaßt und ausgesendet werden.

2. Verfahren nach Anspruch 1,
**dadurch gekennzeichnet,**
daß anstelle eines in ein Datenwort (aa = 01, 10, 11) umgesetzten DPCM-Wertes eine nicht genutzte Binärkombination (00) als Steuersignal übertragen wird.

3. Verfahren nach Anspruch 1,
**dadurch gekennzeichnet,**
daß in einem Datenblock anstelle von DPCM-Werten ein PCM-Signalwert (PCM) mit einer zugehörigen Präambel (LLL0) übertragen.

4. Verfahren nach einem der vorhergehenden Ansprüche,
**dadurch gekennzeichnet,**
daß zu Beginn einer Fernsehzeile ein Datenblock übertragen wird, der ein Synchronwort enthält.

5. Verfahren nach Anspruch 4,
**dadurch gekennzeichnet,**
daß in dem Datenblock außer dem Synchronwort eine Prädiktorkennung (P) übertragen wird.

6. Verfahren nach einem der vorhergehenden Ansprüche,
**dadurch gekennzeichnet,**
daß in einem Datenblock eine Run-Length-Codierung (RL) mit der Anzahl der dem Wert Null entsprechenden DPCM-Werten mit einer zugehörigen Präambel (LLLL0) übertragen wird.

7. Verfahren nach einem der vorhergehenden Ansprüche,
**dadurch gekennzeichnet,**
daß die Übertragung von DPCM-Werten ( Δs) durch Datenwörter (aa, bbb, cccc) mit jeweils 2, 3 und 4 Bits erfolgt.

8. Verfahren nach Anspruch 7,
**dadurch gekennzeichnet,**
daß Datenblöcke mit 11 Bits Länge übertragen werden.

9. Verfahren nach einem der vorhergehenden Ansprüche,
**dadurch gekennzeichnet,**
daß empfangsseitig eine Umsetzung von Datenwörtern (aa, bbb, cccc) in DPCM-Werte ($\Delta$s) durchgeführt wird, die einem DPCM-Empfänger zugeführt werden, der hieraus PCM-Signalwerte (s) rekonstruiert.

10. Verfahren nach Anspruch 8,
**dadurch gekennzeichnet,**
daß eine Blocklänge von 14 Bits inklusive einer Präambel von mindestens 2 Bits vorgesehen ist.

FIG 1

FIG 2

0 244 729

## FIG 3

## FIG 4

0 244 729

## FIG 5

5.1   0 | a a | a a | a a | a a | a a

5.2   1 0 | b b | b | b b | b | b b | b

5.3   1 1 0 | c c c c | c c c c

5.4   1 1 1 0 | PCM

5.5   1 1 1 1 0 | RL

5.6   0 1 1 0 0 0 0 1 0 1 | P

5.7   1 1 1 1 1 1 0 | c c c c

## FIG 6

6.1   0 | a a | a a | a a | a a | a a

6.2   1 1 | b b | b | b b | b | b b | b

6.3   1 0 1 | c c c c | c c c c

6.4   1 0 0 | PCM

6.5   0 0 0 0 0 1 | RL

6.6   0 1 1 0 0 0 0 1 | 1 0 1

6.7   0 1 1 0 0 0 0 1 | 0 1 0

                                  P

FIG 7

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | DE-A-3 403 307  (SIEMENS)<br>* Figuren; Seite 4, Zeile 15 - Seite 7, Zeile 7 * | 1,9 | H 03 M    7/30<br>H 04 B   14/04 |
| Y | COMMUNICATIONS OF THE ACM, Band 18, Nr. 1, Januar 1975, Seiten 49-52, Association for Computing Machinery, Inc., New York, US; T.C. CHEN et al.: "Storage-efficient representation of decimal data"<br>* Figuren 1,3; Seite 50, linke Spalte, Zeile 30 - Seite 51, rechte Spalte, Zeile 25 * | 1,9 | |
| Y | IEEE PROCEEDINGS OF THE INTERNATIONAL CONFERENCE ON ACOUSTICS, SPEECH AND SIGNAL PROCESSING, 9.-11. April 1980, Band 2, Seiten 535-538, IEEE, New York, US; B.S. ATAL et al.: "Improved quantizer for adaptive predictive coding of speech signals at low bit rates"<br>* Seite 538, linke Spalte, Zeile 6 - rechte Spalte, Zeile 2 * | 1,9 | RECHERCHIERTE SACHGEBIETE (Int. Cl.4)<br><br>H 04 B<br>H 03 M |
| Y | COMPUTER DESIGN, Band 12, Nr. 4, April 1973, Seite 98, Concord, Mass., US; H.P. KATSEFF: "Efficient character storage in 16-bit computers"<br>* Seite 98 * | 1,9 | |

-/-

Der vorliegende Recherchenbericht wurde für alle Patentansprüche erstellt.

| Recherchenort | Abschlußdatum der Recherche | Prüfer |
|---|---|---|
| DEN HAAG | 04-08-1987 | FEUER F.S. |

Europäisches
Patentamt

**EUROPÄISCHER RECHERCHENBERICHT**

Nummer der Anmeldung

EP 87 10 6091

Seite 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | IEEE TRANSACTIONS ON COMMUNICATIONS, Band COM-23, Nr. 9, September 1975, Seiten 935-941, New York, US; D.L. COHN et al.: "The residual encoder - An improved ADPCM system for speech digitization" * Tafel IV, V, VI; Seite 939, linke Spalte, Zeile 6 - rechte Spalte, Zeile 6 * | 1,9 | |

RECHERCHIERTE SACHGEBIETE (Int. Cl.4)

Der vorliegende Recherchenbericht wurde für alle Patentansprüche erstellt.

| Recherchenort | Abschlußdatum der Recherche | Prüfer |
|---|---|---|
| DEN HAAG | 04-08-1987 | FEUER F.S. |